# DEMANDE DE BREVET EUROPEEN

(11) **EP 3 606 303 A1**
(43) Date de publication de la demande: **05.02.2020**
(21) Numéro de dépôt: 19186935.3
(22) Date de dépôt: 18.07.2019
(51) Int. Cl.: H05K 7/14, B60L 50/51

(54) **BARRE DE CONNEXION ÉLECTRIQUE, NOTAMMENT POUR UN ONDULEUR DE VÉHICULE**

(30) Priorité: 31.07.2018 FR 1857185
(71) Demandeur: Valeo Siemens eAutomotive France SAS, 95800 Cergy (FR)
(72) Inventeur: POUILLY, Aurélien, 78300 POISSY (FR); CONDAMIN, Bruno, 95300 PONTOISE (FR); LEGENDRE, Alexandre, 95280 JOUY-LE-MOUTIER (FR)
(74) Mandataire: Argyma

(57) **Abrégé**

L'invention porte sur une barre de connexion électrique (1) destinée à relier électriquement un premier équipement électrique (2) et un deuxième équipement électrique (3), notamment dans un véhicule, la barre de connexion électrique (1) comprenant un module de connexion électrique (11) configuré de manière à alimenter le premier équipement électrique (2) avec une énergie électrique commandée par le deuxième équipement électrique (3). La barre de connexion électrique (1) comprend en outre un module de transmission (31) destiné à transmettre dans le deuxième équipement électrique (3) un signal électrique représentatif d'une propriété physique du premier équipement électrique (2), le module de transmission (31) étant intégré avec le module de connexion électrique (11).

## Description

L'invention concerne, de façon générale, les barres de connexion électrique, notamment installées dans les véhicules automobiles.

L'invention porte plus particulièrement sur une barre de connexion électrique couplée entre un premier équipement électrique et un deuxième équipement électrique, notamment entre un moteur électrique et un onduleur, par exemple configurés pour être embarqués dans un véhicule.

Dans un véhicule électrique (d'un acronyme « EV » de l'anglais « Electric Vehical ») ou un véhicule hybride électrique (d'un acronyme « HEV » de l'anglais « Hybrid Electric Vehical »), un onduleur est configuré pour convertir un courant continu haute tension en courant alternatif. Le moteur électrique du véhicule est ainsi alimenté avec le courant alternatif généré par l'onduleur.

Il existe plusieurs solutions concernant la connexion entre l'onduleur et le moteur électrique. Par exemple, il existe des systèmes de motorisation électrique dans lesquels l'onduleur est couplé au moteur électrique en utilisant un module de connexion électrique installé sur une barre de connexion électrique. Pour réaliser la connexion entre l'onduleur et d'autres équipements tels qu'un résolveur et un module de verrouillage (de l'anglais « Interlock System »), un ou plusieurs modules de connexion sont respectivement installé(s) sur une ou plusieurs barres de connexion électrique distincte(s) de la barre de connexion électrique décrite ci-dessus, qui permet de connecter l'onduleur aux phases du moteur électrique. Cette configuration de connexions ne peut pas facilement s'adapter à une configuration plus modularisée des équipements du véhicule, ce qui engendre un encombrement important afin de loger ces équipements, ainsi qu'une pluralité de barres de connexion. Néanmoins, notamment dans un véhicule EV ou HEV de taille modeste, l'espace dans un compartiment moteur est souvent limité.

L'invention vise donc à résoudre les inconvénients ci-dessus en proposant une barre de connexion électrique, afin d'améliorer la configuration des équipements installés dans le compartiment moteur et de réduire l'espace nécessité pour loger ces équipements dans le compartiment moteur du véhicule.

Pour parvenir à ce résultat, la présente invention concerne une barre de connexion électrique destinée à relier électriquement un premier équipement électrique et un deuxième équipement électrique, notamment dans un véhicule. La barre de connexion électrique comprend un module de connexion électrique configuré de manière à alimenter le premier équipement électrique avec une énergie électrique commandée par le deuxième équipement électrique. La barre de connexion électrique comprend en outre un module de transmission destiné à transmettre dans le deuxième équipement électrique un signal électrique représentatif d'une propriété physique du premier équipement électrique, le module de transmission étant intégré avec le module de connexion électrique.

L'invention permet ainsi de réduire le nombre de barres de connexion électrique, d'améliorer la modularisation de ces équipements et de réduire également l'espace nécessaire pour loger les équipements dans le compartiment moteur du véhicule.

De manière préférentielle, la barre de connexion électrique comprend un module de verrouillage destiné à être couplé à un élément de fermeture/ouverture du premier équipement électrique et configuré pour désactiver le premier équipement électrique lorsque l'élément de fermeture/ouverture est actionné de façon à ouvrir le deuxième équipement électrique, ledit module de verrouillage étant intégré avec le module de connexion électrique.

Avantageusement, le module de transmission comprend un connecteur configuré pour s'engager avec un connecteur correspondant du premier équipement électrique.

Préférentiellement, le connecteur du module de transmission est fixé sur la barre de connexion électrique de manière à être mobile en translation.

De façon avantageuse, la barre de connexion électrique comprend un corps en matériau isolant électrique, le module de connexion électrique comportant au moins un conducteur électrique configuré pour alimenter le premier équipement électrique avec un courant généré par le deuxième équipement électrique, le module de transmission comprenant au moins un conducteur électrique configuré pour transmettre dans le deuxième équipement électrique ledit signal électrique représentatif d'une propriété physique du premier équipement électrique, ledit corps maintenant ensemble lesdits conducteurs électriques du module de connexion électrique et du module de transmission.

Préférentiellement, le module de verrouillage comprend au moins un conducteur électrique configuré pour être connecté à un circuit électrique du deuxième équipement électrique, ledit corps maintenant ensemble ledit au moins un conducteur électrique du module de verrouillage avec les conducteurs électriques du module de connexion électrique et du module de transmission.

De manière préférentielle, le corps comprend une première portion, dite portion d'interface, destinée à coopérer avec une interface entre le premier et le deuxième équipements électriques, et dans lequel :
- une première partie de la barre de connexion électrique s'étend d'un premier côté de la portion d'interface du corps, de manière à être logée au moins en partie dans le premier équipement, et
- une deuxième partie de la barre de connexion électrique s'étend d'un deuxième côté de la portion d'interface du corps, de manière à être logée au moins en partie dans le deuxième équipement électrique.

Avantageusement, le corps comprend une deuxième portion s'étendant transversalement depuis la portion d'interface et comprise dans la deuxième partie de la barre de connexion électrique, ladite deuxième portion formant un support du connecteur du module de transmission.

Préférentiellement, la deuxième portion du corps forme un support d'un détecteur du module de verrouillage, ledit détecteur étant configuré pour détecter lorsque ledit élément de fermeture/ouverture est actionné de façon à ouvrir le deuxième équipement électrique.

L'invention concerne également un système électrique, notamment destiné à être embarqué dans un véhicule, comprenant un premier équipement électrique, un deuxième équipement électrique et une barre de connexion électrique telle que brièvement décrite ci-dessus, ladite barre de connexion électrique étant montée à une interface entre le premier équipement électrique et le deuxième équipement électrique.

De manière préférentielle, le premier équipement électrique et le deuxième équipement électrique sont respectivement installés dans un boîtier correspondant, le boîtier dans lequel le premier équipement électrique est installé comportant un élément de fermeture/ouverture configuré pour la fermeture/ouverture du boîtier.

Avantageusement, l'élément de fermeture/ouverture forme un actionneur configuré pour actionner un module de verrouillage de la barre de connexion électrique lorsque l'élément de fermeture/ouverture ferme ou ouvre le boîtier du premier équipement électrique.

Préférentiellement, l'élément de fermeture/ouverture forme un couvercle du boîtier et comprend une excroissance, notamment une tige, ladite excroissance étant formée à une surface interne du couvercle et destinée à :
- appuyer sur un détecteur du module de verrouillage lorsque le couvercle est fermé de manière à permettre un fonctionnement du deuxième équipement électrique ; et
- relâcher ledit détecteur lorsque le couvercle est ouvert de manière à désactiver le deuxième équipement électrique.

De façon avantageuse, le système électrique comprend la barre de connexion électrique telle que brièvement décrite ci-dessus, dans lequel l'élément de fermeture/ouverture forme un actionneur configuré pour, lorsque l'élément de fermeture/ouverture ferme le boîtier du premier équipement électrique, appuyer sur le connecteur du module de transmission de la barre de connexion électrique de manière à le déplacer vers un connecteur correspondant du premier équipement électrique.

Préférentiellement, le premier équipement électrique forme un moteur électrique et le deuxième équipement électrique forme un onduleur commandant ledit moteur électrique.

D'autres caractéristiques et avantages de l'invention apparaîtront à la lecture de la description détaillée des modes de réalisation de l'invention, donnés à titre d'exemple uniquement, et en référence aux dessins qui montrent :
- la figure 1, une vue schématique en perspective d'un exemple de barre de connexion selon l'invention,
- la figure 2, une vue schématique en perspective d'un mode de repos d'un module de verrouillage de la barre de connexion électrique de la barre de connexion de la figure 1,
- la figure 3, une vue schématique en perspective d'un mode d'emploi du module de verrouillage de la barre de connexion électrique de la figure 1.

Dans ce qui va suivre, les modes de réalisation décrits s'attachent plus particulièrement à une mise en oeuvre d'un exemple de barre de connexion électrique selon l'invention. Cependant, toute mise en oeuvre dans un contexte différent, en particulier dans tout type de véhicule, est également visée par la présente invention.

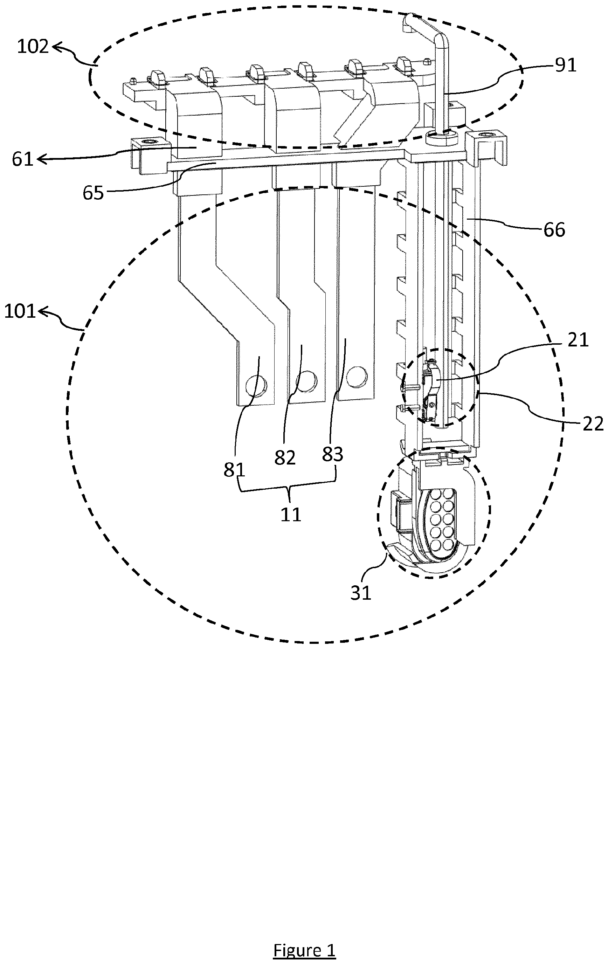

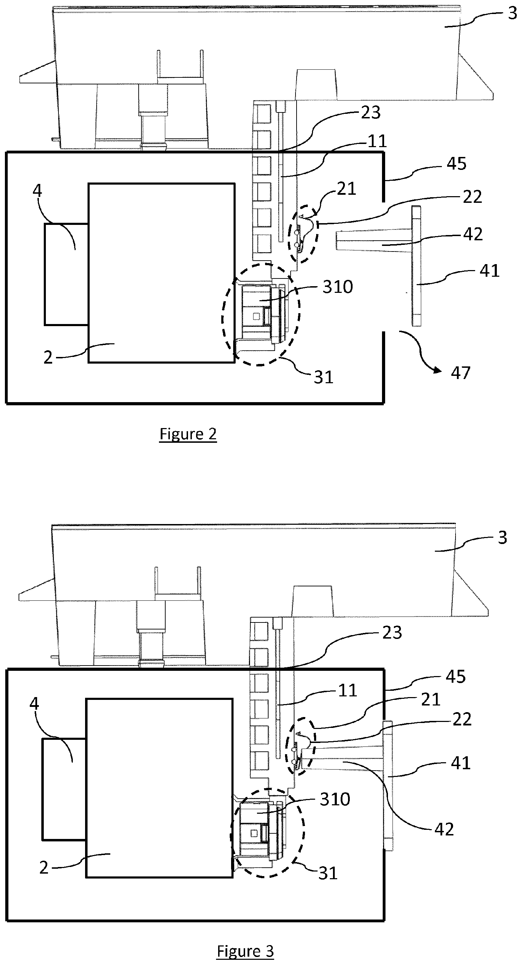

La figure 1 représente une vue schématique en perspective d'une barre de connexion électrique 1 selon l'invention. La barre de connexion électrique 1 est destinée à relier électriquement un premier équipement électrique 2 et un deuxième équipement électrique 3 du véhicule, ce qui sera montré plus en détail en figures 2 et 3. Dans un cas général, la barre de connexion électrique 1, le premier équipement électrique 2 et le deuxième équipement électrique 3 sont logés dans un compartiment moteur du véhicule. De manière préférentielle, le premier équipement électrique 2 est un moteur électrique 2, et le deuxième équipement électrique 3 est un onduleur 3.

La barre de connexion électrique 1 comprend un module de connexion électrique 11, un module de transmission 31 et peut comprendre un module de verrouillage 21. Le module de connexion électrique 11 est configuré de manière à alimenter le premier équipement électrique 2 avec une énergie électrique commandée par le deuxième équipement électrique 3. De manière préférentielle, le premier équipement électrique 2 est logé dans un boîtier 45 dans le compartiment moteur du véhicule, et est configuré pour réaliser une conversion d'une énergie électrique en énergie mécanique. Le deuxième équipement électrique 3, comme mentionné ci-dessus, est configuré pour générer le courant alternatif afin d'alimenter le premier équipement électrique 2. Selon un mode de réalisation, le deuxième équipement électrique 3 est installé dans un boîtier distinct du boîtier 45 dans lequel le premier équipement électrique 2 est installé. Cependant, les boitiers du premier 2 et du deuxième 3 équipements électriques peuvent être assemblés ensemble de sorte que des parois externes respectives viennent l'une contre l'autre. En particulier, la barre de connexion électrique 1 traverse ces parois pour connecter le premier 2 et le deuxième 3 équipements électriques.

Dans un mode de réalisation préférentiel, le deuxième équipement électrique 3 est un onduleur triphasé (désigné « Three-Phase Inverter » en langue anglaise) configuré pour générer trois courants respectivement sinusoïdaux l'un à l'autre. L'invention n'est néanmoins pas limitée au type du deuxième équipement électrique 3. Le premier équipement électrique 2 comprend au moins un conducteur 81, 82, and 83. Notamment, le module de connexion électrique 11 comprend une pluralité de conducteurs 81, 82, and 83 fixés au premier équipement électrique 2 et respectivement configurés pour alimenter le premier équipement électrique 2 avec un courant généré par le deuxième équipement électrique 3. Ceci est en particulier le cas dans un exemple où le deuxième équipement électrique 3 est un onduleur triphasé. De manière préférentielle, les conducteurs 81, 82, and 83 sont en matériau conducteur électrique, par exemple en métal. La fixation des conducteurs 81, 82, and 83 au premier équipement électrique 2 est notamment réalisée par vis. L'invention n'est néanmoins ni limitée au nombre de conducteurs ni au mode de fixation des conducteurs du module de connexion électrique 11 au premier équipement électrique 2.

Dans un mode de réalisation préférentiel, la barre de connexion électrique 1 est montée au moins en partie dans le deuxième équipement électrique 3. De manière avantageuse, la barre de connexion électrique 1 est installée au moins en partie dans le boîtier 45 dans lequel le premier équipement électrique 2 est logé.

Le module de transmission 31, intégré avec le module de connexion électrique 11 dans la barre de connexion électrique 1, vient se connecter à un connecteur correspondant du premier équipement électrique 2 délivrant un signal électrique représentatif d'une propriété physique du premier équipement électrique 2. Ladite propriété physique du premier équipement électrique 2 comprend la température et/ou la vitesse et/ou la position d'un rotor du premier équipement électrique 2 détectée(s) par un capteur du premier équipement électrique 2, tel qu'un capteur de température ou un capteur de position. Selon un mode de réalisation préférentiel, le capteur de position est un capteur standard. De manière avantageuse, le capteur de position est un résolveur.

Selon un mode de réalisation avantageux, le module de transmission 31 comprend au moins un conducteur électrique configuré pour transmettre dans le deuxième équipement électrique 3 ledit signal électrique représentatif de la propriété physique du premier équipement électrique 2. A cette fin, le module de transmission 31 comprend un connecteur 310 apte à s'engager dans un connecteur correspondant du premier équipement électrique 2, notamment de façon mobile en translation. Ainsi, le module de transmission 31 est de préférence fixé sur la barre de connexion électrique 1 de manière à être mobile en translation, notamment au niveau du connecteur 310 du module de transmission 31.

Selon un mode de réalisation avantageux, la barre de connexion électrique 1 comprend un corps 61 de préférence en matériau isolant électrique. Le corps 61 maintient ensemble lesdits conducteurs électriques du module de connexion électrique 11 et du module de transmission 31.

Comme illustré en figure 1, le corps 61 comprend une première portion 65, dite portion d'interface 65, destinée à coopérer avec une interface 23 entre le premier équipement électrique 2 et le deuxième équipement électrique 3. De manière avantageuse, la portion d'interface 65 du corps 61 comprend au moins un joint d'étanchéité configuré pour coopérer avec ladite interface 23 de manière à garantir une étanchéité entre le premier équipement électrique 2 et le deuxième équipement électrique 3.

La barre de connexion électrique 1 comprend une première partie 101 s'étendant d'un premier côté de la portion d'interface 65 du corps 61, de manière à être logée au moins en partie dans le premier équipement électrique 2. La barre de connexion électrique 1 comprend en outre une deuxième partie 102 s'étendant d'un deuxième côté de la portion d'interface 65 du corps 61, de manière à être logée au moins en partie dans le deuxième équipement électrique 3.

Selon un mode de réalisation, le système comprenant le premier 2 et le deuxième 3 équipements électriques, comprend en outre un troisième équipement 4, notamment un équipement mécanique tel qu'une boite de vitesse. Dans un cas général, la boîte de vitesses 4 est installée dans le boîtier 45 du premier équipement électrique 2. Dans ce cas, tous les composants à l'intérieur du boîtier 45, en particulier ladite première partie de la barre de connexion électrique 1, sont dans un milieu où de l'huile est présente. La barre de connexion électrique 1 est alors particulièrement avantageuse car elle intègre plusieurs modules en un seul élément, et permet ainsi de gérer l'étanchéité une seule fois, notamment au niveau de la portion d'interface 65 du corps 61 de la barre de connexion électrique 1. La barre de connexion électrique 1 présente ainsi une résistance à des fluides de moteur et/ou à ceux de la boîte de vitesse 4. Il est noté que dans un autre cas avec une configuration différente, la boîte de vitesses 4 est installée à l'extérieur du boîtier 45 du premier équipement électrique 2.

Le corps 61 comprend une deuxième portion 66 s'étendant transversalement depuis la portion d'interface 65 et comprise dans la deuxième partie de la barre de connexion électrique 1. La deuxième portion 66 forme un support de l'au moins un conducteur électrique du module de transmission 31. La deuxième portion 66 forme en outre un support du connecteur 310 du module de transmission 31. En particulier, le connecteur 310 est monté à une extrémité distale de la deuxième portion 66 du corps 61 par rapport à la portion d'interface 65.

Le module de verrouillage 21 est notamment configuré pour décharger le deuxième équipement électrique 3. La décharge de l'énergie électrique présente dans le deuxième équipement électrique 3 est actionnée par le module de verrouillage 21. De manière préférentielle, le module de verrouillage 21, couplé à un élément de fermeture/ouverture 41 du premier équipement électrique 2 (illustré ultérieurement), est intégré avec le module de connexion électrique 11 dans la barre de connexion électrique 1. Le module de verrouillage 21 est configuré pour désactiver le premier équipement électrique 2 lorsque l'élément de fermeture/ouverture 41 est actionné de façon à ouvrir le deuxième équipement électrique 3.

Comme illustré en figure 1, le module de verrouillage 21 comprend au moins un conducteur électrique configuré pour être connecté à un circuit électrique du deuxième équipement électrique 3. De manière préférentielle, un câble 91 contenant les conducteurs électriques (se présentant sous la forme de fils électriques) du module de verrouillage 21 et du module de transmission 31 est maintenu sur le corps 61, notamment sur la deuxième portion 66 du corps 61. A cet effet, la deuxième portion 66 peut comprendre des encoches. Le corps 61 de la barre de connexion électrique 1 maintient ainsi ensemble ledit au moins un conducteur électrique du module de verrouillage 21 avec les conducteurs électriques du module de connexion électrique 11 et du module de transmission 31.

La deuxième portion 66 du corps 61 forme un support d'un détecteur 22 du module de verrouillage 21. Le détecteur 22 est configuré pour détecter lorsque l'élément de fermeture/ouverture 41 est actionné de façon à ouvrir le deuxième équipement électrique 3.

Un exemple non limitatif de l'invention illustrant un déclenchement de la décharge d'énergie électrique du deuxième équipement électrique 3 sera décrit en détail en paragraphes suivants et en figures 2 et 3.

La figure 2 représente une vue schématique en perspective d'un mode de repos du module de verrouillage 21 de la barre de connexion électrique 1. Comme décrit en figure 2, le boîtier 45 comprend l'élément de fermeture/ouverture 41 qui correspond avec une ouverture 47 formée sur le boîtier 45. L'élément de fermeture/ouverture 41 forme un actionneur configuré pour actionner, en coopération avec le détecteur 22, le module de verrouillage 21 lorsque l'élément de fermeture/ouverture 41 ferme ou ouvre le boîtier 45 du premier équipement électrique 2. De plus, l'élément de fermeture/ouverture 41 peut être également configuré pour appuyer sur le connecteur 310 du module de transmission 31 de manière à le déplacer vers un connecteur correspondant du premier équipement électrique 2.

De manière avantageuse, l'élément de fermeture/ouverture 41 comprend un couvercle 41 amovible et une excroissance 42. En particulier, le détecteur 22 comprend un bouton sur lequel l'excroissance 42 vient en appui. L'excroissance 42 est formée à une surface interne du couvercle 41 et est destinée à relâcher le détecteur 22, notamment le bouton, lorsque le couvercle 41 est ouvert de manière à désactiver le deuxième équipement électrique 3. Selon un mode de réalisation, l'excroissance 42 est une tige 42 s'étendant depuis une surface interne du couvercle 41 et préférentiellement perpendiculaire de ladite surface interne.

La figure 3 représente une vue schématique en perspective d'un mode d'emploi du module de verrouillage 21 de la barre de connexion électrique 1. Lorsque l'élément de fermeture/ouverture 41 ferme le boîtier 45, la tige 42 s'approche, à travers l'ouverture 47, du détecteur 22 du module de verrouillage 21. L'excroissance 42 est donc destinée à appuyer sur le détecteur 22, notamment le bouton du détecteur 22, lorsque l'élément de fermeture/ouverture 41 est fermé de manière à permettre un fonctionnement du deuxième équipement électrique 3.

Selon un mode de réalisation préférentiel, le détecteur 22 est un interrupteur 22 configuré pour ouvrir un circuit électrique du deuxième équipement électrique 3 lorsque ledit élément de fermeture/ouverture 41 est actionné. Selon un mode de réalisation alternatif, le détecteur 22 pourrait être un capteur envoyant un front électrique vers le deuxième équipement électrique 3 lors d'une ouverture du boîtier 45 dans lequel où le premier équipement électrique 2 est installé. Le détecteur 22 est, comme mentionné précédemment et illustré en figure 2, configuré pour désactiver le deuxième équipement électrique 3 quand le détecteur 22 est relâché.

Comme décrit ci-dessus, le module de verrouillage 21 est installé dans la même barre de connexion électrique 1 que le module de connexion électrique 11, ce qui permet d'améliorer l'intégration d'un système électrique comprenant le premier équipement électrique 2 et le deuxième équipement électrique 3. Le module de verrouillage 21 permet notamment de garantir une décharge de condensateurs du deuxième équipement électrique 3 lorsque le boîtier 45 comprenant le premier équipement électrique 2 est ouvert par un opérateur. Ainsi, l'opérateur peut accéder aux composants, tels que les conducteurs électriques de la barre de connexion électrique 1, de manière sécurisée sans risquer une électrocution. Un diagnostic de véhicule peut donc être effectué de manière sécurisée par le technicien ou le conducteur.

Grâce à l'intégration d'au moins deux des trois modules comprenant le module de connexion électrique, le module de verrouillage et le module de transmission toutes dans la même barre de connexion électrique, l'invention permet d'améliorer la modularisation et l'étanchéité des équipements installés dans le compartiment moteur ainsi que de réduire l'espace nécessité pour loger ces équipements dans le compartiment moteur du véhicule.

## Revendications

1. Barre de connexion électrique (1) destinée à relier électriquement un premier équipement électrique (2) et un deuxième équipement électrique (3), notamment dans un véhicule, la barre de connexion électrique (1) comprenant un module de connexion électrique (11) configuré de manière à alimenter le premier équipement électrique (2) avec une énergie électrique commandée par le deuxième équipement électrique (3) ; **caractérisée en ce que** la barre de connexion électrique (1) comprend :
un module de transmission (31) destiné à transmettre dans le deuxième équipement électrique (3) un signal électrique représentatif d'une propriété physique du premier équipement électrique (2), le module de transmission (31) étant intégré avec le module de connexion électrique (11).

2. Barre de connexion électrique (1) selon la revendication 1, comprenant un module de verrouillage (21) destiné à être couplé à un élément de fermeture/ouverture (41) du premier équipement électrique (2) et configuré pour désactiver le premier équipement électrique (2) lorsque l'élément de fermeture/ouverture (41) est actionné de façon à ouvrir le deuxième équipement électrique (3), ledit module de verrouillage (21) étant intégré avec le module de connexion électrique (11).

3. Barre de connexion électrique (1) selon la revendication 1 ou 2, dans lequel le module de transmission (31) comprend un connecteur (310) configuré pour s'engager avec un connecteur correspondant du premier équipement électrique (2).

4. Barre de connexion électrique (1) selon la revendication 3, dans lequel le connecteur (310) du module de transmission (31) est fixé sur la barre de connexion électrique (1) de manière à être mobile en translation.

5. Barre de connexion électrique (1) selon l'une quelconque des revendications précédentes, comprenant un corps (61) en matériau isolant électrique, le module de connexion électrique (11) comportant au moins un conducteur électrique (81, 82, 83) configuré pour alimenter le premier équipement électrique (2) avec un courant généré par le deuxième équipement électrique (3), le module de transmission (31) comprenant au moins un conducteur électrique configuré pour transmettre dans le deuxième équipement électrique (3) ledit signal électrique représentatif d'une propriété physique du premier équipement électrique (2), ledit corps (61) maintenant ensemble lesdits conducteurs électriques du module de connexion électrique (11) et du module de transmission (31).

6. Barre de connexion électrique (1) selon la revendication précédente et la revendication 2, dans lequel le module de verrouillage (21) comprend au moins un conducteur électrique configuré pour être connecté à un circuit électrique du deuxième équipement électrique (3), ledit corps (61) maintenant ensemble ledit au moins un conducteur électrique du module de verrouillage (21) avec les conducteurs électriques du module de connexion électrique (11) et du module de transmission (31).

7. Barre de connexion électrique (1) selon la revendication 5 ou 6, dans lequel le corps (61) comprend une première portion (65), dite portion d'interface (65), destinée à coopérer avec une interface (23) entre le premier (2) et le deuxième (3) équipements électriques, et dans lequel :
- une première partie (101) de la barre de connexion électrique (1) s'étend d'un premier côté de la portion d'interface (65) du corps (61), de manière à être logée au moins en partie dans le premier équipement (2) ; et
- une deuxième partie (102) de la barre de connexion électrique (1) s'étend d'un deuxième côté de la portion d'interface (65) du corps (61), de manière à être logée au moins en partie dans le deuxième équipement électrique (3).

8. Barre de connexion électrique (1) selon les revendications 7 et 3, dans lequel le corps (61) comprend une deuxième portion (66) s'étendant transversalement depuis la portion d'interface (65) et comprise dans la deuxième partie (102) de la barre de connexion électrique (1), ladite deuxième portion (66) formant un support du connecteur (310) du module de transmission (31).

9. Barre de connexion selon les revendications 8 et 2, dans lequel la deuxième portion (66) du corps forme un support d'un détecteur (22) du module de verrouillage (21), ledit détecteur (22) étant configuré pour détecter lorsque ledit élément de fermeture/ouverture (41) est actionné de façon à ouvrir le deuxième équipement électrique (3).

10. Système électrique, notamment destiné à être embarqué dans un véhicule, comprenant un premier équipement électrique (2), un deuxième équipement électrique (3) et une barre de connexion électrique (1) selon l'une des revendications précédentes, ladite barre de connexion électrique (1) étant montée à une interface (23) entre le premier équipement électrique (2) et le deuxième équipement électrique (3).

11. Système électrique selon la revendication précédente, dans lequel le premier équipement électrique (2) et le deuxième équipement électrique (3) sont respectivement installés dans un boîtier correspondant, le boîtier (45) dans lequel le premier équipement électrique (2) est installé comportant un élément de fermeture/ouverture (41) configuré pour la fermeture/ouverture dudit boîtier (45).

12. Système électrique selon la revendication précédente, dans lequel l'élément de fermeture/ouverture (41) forme un actionneur configuré pour actionner un module de verrouillage (21) de la barre de connexion électrique (1) lorsque l'élément de fermeture/ouverture (41) ferme ou ouvre le boîtier (45) du premier équipement électrique (2).

13. Système électrique selon la revendication précédente, comprenant une barre de connexion électrique (1) selon la revendication 2, dans lequel l'élément de fermeture/ouverture (41) forme un couvercle (41) du boîtier (45) et comprend une excroissance (42), notamment une tige, ladite excroissance (42) étant formée à une surface interne du couvercle (41) et destinée à :
- appuyer sur un détecteur (22) du module de verrouillage (21) lorsque le couvercle (41) est fermé de manière à permettre un fonctionnement du deuxième équipement électrique (3) ; et
- relâcher ledit détecteur (22) lorsque le couvercle (41) est ouvert de manière à désactiver le deuxième équipement électrique (3).

14. Système électrique selon l'une des revendications 11 à 13, comprenant une barre de connexion électrique (1) selon la revendication 4, dans lequel ledit élément de fermeture/ouverture (41) forme un actionneur configuré pour, lorsque l'élément de fermeture/ouverture (41) ferme le boîtier (45) du premier équipement électrique (2), appuyer sur le connecteur (310) du module de transmission (31) de la barre de connexion électrique (1) de manière à le déplacer vers un connecteur correspondant du premier équipement électrique (2).

15. Système électrique selon une des revendications 10 à 14, dans lequel le premier équipement électrique (2) forme un moteur électrique (2) et le deuxième équipement électrique (3) forme un onduleur (3) commandant ledit moteur électrique (2).
